# EUROPÄISCHE PATENTSCHRIFT

(11) **EP 1 080 244 B1**
(45) Veröffentlichungstag und Bekanntmachung des Hinweises auf die Patenterteilung: **05.12.2001**
(21) Anmeldenummer: 99952100.8
(22) Anmeldetag: 17.05.1999
(51) Int. Cl.: C23C 14/06, C23C 16/26, B23K 35/22, H01H 1/02

(54) **ANTI-HAFT-BESCHICHTUNG UND VERFAHREN ZU IHRER HERSTELLUNG**
ANTI-ADHERENT COATING AND METHOD FOR THE PRODUCTION THEREOF
REVETEMENT ANTI-ADHESIF ET SON PROCEDE DE PRODUCTION

(30) Priorität: 18.05.1998 DE 19822273
(43) Veröffentlichungstag der Anmeldung: 07.03.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: WITTDORF, Ralf, D-38100 Braunschweig (DE); BRAND, Jochen, D-38126 Braunschweig (DE)
(86) Internationale Anmeldenummer: EP9903381
(87) Internationale Veröffentlichungsnummer: WO9960183

(56) Entgegenhaltungen:
- WO-A-94/12680
- GB-A- 2 269 105
- US-A- 5 100 701
- DE MARTINO C ET AL: "Improvement of mechanical properties of a-C:H by silicon addition" DIAMOND AND RELATED MATERIALS, Bd. 6, Nr. 5-7, 1. April 1997 (1997-04-01), Seite 559-563 XP004081096 ISSN: 0925-9635

## Beschreibung

### Technisches Gebiet

Die Erfindung betrifft eine Anti-Haft-Beschichtung für Schweiß- und Lötvorrichtungen sowie und elektrischen Kontakten nach dem Oberbegriff des Anspruchs 1 sowie ein Verfahren zu seiner Herstellung gemäß Anspruch 7. Bevorzugtes Anwendungsgebiet ist der Schutz von Halterungs- Führungs- und Fixiereinrichtungen von Schweiß- und/oder Lötvorrichtungen, und insbesondere von automatisierten Schweißstraßen im Automobilbau.

### Stand der Technik

In der US 4,156,807 wird vorgeschlagen, zum Schutz eines Werkstückes gegen metallische Verunreinigungen in Form von heißen Schweißspritzern oder Schweißperlen eine Bornitridschicht aufzubringen. Bornitrid ist sehr temperaturbeständig und beugt daher thermisch bedingte Beschädigungen des Werkstückes durch heiße metallische Verunreinigungen vor. Bornitrid ist jedoch relativ weich, so daß es je nach Einsatzbedingungen des zu bearbeitenden Werkstückes zu einer mechanischen Beschädigung der Schicht und damit zu einem Verlust der Schutzwirkung kommen kann. Weiterhin ist Bornitrid ein guter elektrischer Isolator, dessen isolationseigenschaft zum Beispiel bei zu schützenden elektrischen Kontakten unerwünscht ist. Ein weiterer erheblicher Nachteil ist ferner die nur mäßige Antihaftwirkung von Bornitrid gegenüber metallischen Verunreinigungen.

Die DE 41 10 539 A1 lehrt den Schutz eines stark kupferhaitigen Bauteils gegen mikroskopische oder makroskopische Verunreinigungen wie Rauchgase oder Spritzer flüssigen Metalls durch eine Schutzschicht aus Titannitrid- oder Titancarbonitrid. Da die Bauteile in der DE 41 10 539 A1 möglichst wenig in ihren elektrischen Eigenschaften verändert werden sollen eignen sich diese titanbasierten Hartsoffe dort gut wegen ihrer hohen Temperaturstabilität und ihrer guten elektrischen Leitfähigkeit. Nachteilig ist wie bei Bornitrid deren nur mäßige Antihaftwirkung gegenüber metallischen Verunreinigungen. Weiterhin weisen sie den Nachteil auf, daß diese Schutzschichten bei PVD- oder CVD-Prozessen mit typischerweise relativ hohen Temperaturen von mehr als 450 °C abgeschieden werden können. Derartige Schutzschichten auf Titanbasis lassen sich aus diesem Grund bei temperaturempfindlichen Substraten nicht oder nur begrenzt einsetzen. Weiterhin kann die gute elektrische Leitfähigkeit der Anti-Haft-Beschichtung je nach Anwendungsfall unerwünscht sein.

Beim Schutz von Oberflächen gegen metallische Verunreinigungen, zum Beispiel Verunreinigungen von Schweißprozessen wie in den oben genannten Druckschriften kommt es neben dem thermischen Schutz der Oberfläche auch maßgeblich darauf an, daß die metallischen Verunreinigungen nicht auf der Oberfläche anhaften. Die anhaftenden metallischen Verunreinigungen können sowohl zu mechanischen als auch zu elektrischen Fehlfunktionen führen.

Beim Schweißen und Hartlöten werden häufig Führungs-, Fixier- und Klemmvorrichtungen aus Stählen und Gußwerkstoffen eingesetzt, die gegenüber metallischen Verunreinigungen wegen ähnlich hoher Werte in der totalen Oberflächenenergie σ^{tot} stark zum Anhaften neigen. Anhaftende metallische Verunreinigungen führen dort zu einer Maßungenauigkeit der genannten Vorrichtungen, die deshalb häufig ausgewechselt oder nachgearbeitet werden müssen. Derartige Probleme tauchen zum Beispiel in automatisierten Schweißstraßen auf, z.B. im Automobilbau oder bei der Herstellung von Rohren.

Es gibt ferner elektrische Bauteile, wie zum Beispiel Kontaktspitzen, Kontaktfedern oder Kontaktklemmen, welche in der Elektroindustrie zur Funktionsprüfung elektronischer Bauteile vorgesehen sind, die häufig mit Weichloten in Berührung kommen. Wegen der nur geringen Lottemperaturen von anfangs maximals 450 °C besteht das Erfordernis dabei weniger in der Bereitstellung einer thermisch stabilen Schutzschicht, sondern in einer Schutzschicht, welche das Anhaften des aufgeschmierten weichen, meist zinn-oder bleihaltigen Lotes verhindert. Anhaftendes metallisches Lot beeinflußt jedoch auf unkontrollierbare Weise den elektrischen Kontakt was zu elektrischen Fehifunktionen führt. Derartige Kontakte bestehen häufig aus Buntmetallegierungen, und werden aus den genannten Gründen häufig durch galvanische Schichten mit Cr, Ni, Ag, Au geschützt. Diese Schichten weisen zwar die erforderliche elektrische Leitfähigkeit auf, sind aber recht weich und werden schnell abgerieben.

### Darstellung der Erfindung

Der Erfindung liegt die Aufgabe zugrunde, die Probleme nach dem Stand der Technik weitestgehend zu vermeiden und eine Alternative für die oben erwähnten Schutzschichten gegen metallische Verunreinigungen aus Schweiß- und Lötprozessen zur Verfügung zu stellen. Diese alternative Schutzschicht soll thermisch stabil sein und insbesondere gute Antihafteigenschaften gegenüber den meist duktilen metallischen Verunreinigungen aufweisen. Die Anti-Haft-Wirkung soll insbesondere gegenüber den üblicherweise verwendeten Materialien der Schweiß- und Lötvorrichtungen gegeben sein, d.h. vornehmlich gegenüber Stählen und Druckguß.

Eine weitere Aufgabe besteht darin, eine harte Schutzschicht mit gutem Verschleiß- und Reibeigenschaften zur Verfügung zu steilen um mechanisch möglichst universell einsetzbar zu sein.

Weitere Aufgabe ist es eine Antihaftschicht zur Verfügung zu stellen, welche in ihrer elektrischen Leitfähigkeit durchgestimmt werden kann, damit sie hinsichtlich ihres elektrischen Verhaltens möglichst universell einsetzbar ist.

Eine weitere Aufgabe besteht darin eine Antihaftschicht gegen metallische Verunreinigungen zur Verfügung zu stellen, die bei ihrem Aufbringen auf dem zu schützenden Werkstück oder Bauteil dieses möglichst nicht beschädigt.

Erfindungsgemäß wurde erkannt, daß diese Aufgaben durch eine Anti-Haft-Beschichtung nach dem Oberbegriff des Anspruchs 1 in Verbindung mit seinem kennzeichnenden Teil gelöst werden. Vorteilhafte Weiterbildungen der erfindungsgemäßen Anti-Haft-Beschichtung werden in den abhängigen Ansprüchen gegeben. Das erfindungsgemäße Verfahren zur Herstellung dieser Beschichtungen erfolgt nach dem Oberbegriff des Anspruchs 7 in Verbindung mit seinem kennzeichnenden Teil.

Die erfindungsgemäßen Beschichtungen aus diamantartigem Kohlenstoff zur Verhinderung des Anhaftens metallischer Verunreinigungen von Schweiß- und/oder Lötprozessen auf einer Oberfläche sind sehr hart, temperaturstabil, adhäsionshemmend, zeigen ein sehr gutes Verschleißverhalten und ein günstiges Reibverhalten. Diese Beschichtungen lassen sich insbesondere durch Gasphasenabscheidung, und insbesonders mittels des PVD- oder des CVD-Verfahrens leicht und kostengünstig abscheiden. Dadurch ist die Abscheidung auch auf gekrümmten Oberflächen mit komplizierter Oberflächengeometrie möglich. Auch eine partielle Beschichtung der Schweiß- oder Lötvorrichtung ist möglich. Eine partielle Beschichtung kann darin bestehen, daß zumindest die den metallischen Verunreinigungen ausgesetzten Oberflächenbereiche beschichtet sind. Dies sind insbesondere die Führungen sowie Fixier- und Halteeinrichtungen für die zu fügenden Bauteile, aber auch Schweißbacken und Schweißdüsen.

Besonders vorteilhaft im Sinne der vorliegenden Erfindung sind amorphe Kohlenwasserstoffschichten (a-C:H), wasserstofffreie amorphe Kohlenwasserstoffschichten (a:C) und siliciumhaltige Kohlenwasserstoffschichten (Si:C-H). Letztere verfügen über ganz besonders gute Anti-Haft-Eigenschaften, die an diejenigen von Teflon ® heranreichen.

Eigene Untersuchungen ergaben, daß das Problem des Anhaftens metallischer Verunreinigungen weniger bei bereits erkalteten und weitgehend spröden Verunreinigungen kritisch ist. Diese haften nur relativ schwach an der meist metallischen Oberfläche der Schweiß- und Lötvorrichtungen. Problematisch ist vielmehr das starke Anhaften der bei ihrem Auftreffen auf die Oberfläche noch nicht erkalteten und daher noch duktilen Verunreinigungen. Durch die erfindungsgemäßen Anti-Haft-Beschichtungen kann das Anhaften metallischer Verunreinigungen von Schweiß- und Lötprozessen auf den meist aus Stahl oder Druckguß bestehenden Schweiß- und/oder Lötvorrichtungen deutlich reduziert werden. Dies gilt insbesondere bei duktilen metallischen Verunreinigungen wie Schweißperlen, Schweißspritzern, Hart- oder Weichlottropfen. Dadurch bedingte Standzeiten, innerhalb derer die verunreinigten Bauteile ausgewechselt, nachgearbeitet oder gereinigt werden müssen, können erhöht werden. Stillstands- bzw. Wechselzeiten können daher verringert werden.

Die sich insbesondere in automatisierten Schweißstraßen wie im Automobilbau oder der Rohrfertigung einstellende Maßungenauigkeit durch Verunreinigungen der Bauteile wie zum Beispiel Führungen, Fixier- und Halteeinrichtungen kann vermieden werden. Damit können Positionierungsfehler beim Schweißen verhindert und die Entstehung von Ausschuß minimiert werden.

Elektrische Kontakte wie zum Beispiel Kontaktstifte oder Kontaktfedern in der Elektroindustrie, können durch die erfindungsgemäßen Anti-Haft-Beschichtungen effektiv vor Anhaftungen von Hart- oder Weichloten geschützt werden. So können Funktionsstörungen beim Testen von elektronischen Bauteilen vermieden werden. Durch die Wahl einer metallhaltigen Kohlenstoffbeschichtung (Me-C:H-Beschichtung) kann dabei weiterhin ein guter elektrischer Kontakt sichergestellt werden. Durch die Zusammensetzung und durch die Erhöhung des Metallgehaltes, welcher vorzugsweise zwischen 10% und 49,9% liegt, läßt sich die elektrische Leitfähigkeit der Beschichtung erhöhen und auf den jeweiligen Einsatz hin optimieren. Die Metalle, die eingesetzt werden, sind bevorzugt Metalle aus Nebengruppen des Periodensystems der Elemente wie W, Zr, Cr, Au, Ag, Pt, Cu, Ta, Hf und V, aber auch Ti.

Sehr gute Anti-Haft-Eigenschaften ergeben sich insbesondere, wenn die Schichtdicke zwischen 0,2 µm bis 15 µm liegt.

## Patentansprüche

1. Anti-Haft-Beschichtung für Schweiß- und/oder Lötvorrichtungen und elektrischen Kontakten zur Verringerung des Anhaftens metallischer Verunreinigungen auf deren Oberflächen, **dadurch gekennzeichnet, daß** die Beschichtung eine diamantartige Kohlenstoffschicht ist.

2. Beschichtung nach Anspruch 1, **dadurch gekennzeichnet, daß** die Beschichtung eine Schicht aus a-C, a-C:H, Me-C:H oder Si-C:H ist.

3. Beschichtung nach mindestens einem der Ansprüche 1 bis 2, **dadurch gekennzeichnet, daß** die Beschichtung eine Schicht aus Me-C:H ist, wobei das Metall W, Zr, Cr, Au, Ag, Pt, Cu, Ta, Hf, V, oder Ti ist.

4. Beschichtung nach mindestens einem der Ansprüche 2 bis 3, **dadurch gekennzeichnet, daß** der Metallgehalt zwischen 10% und 49,9% liegt.

5. Beschichtung nach mindestens einem der Ansprüche 1 bis 4, **dadurch gekennzeichnet, daß** die Beschichtung eine Dicke zwischen 0,2 µm bis 15 µm aufweist.

6. Beschichtung nach mindestens einem der Ansprüche 1 bis 5, **dadurch gekennzeichnet, daß** die Beschichtung eine durch Gasphasenabscheidung, insbesondere durch ein CVD- oder PVD-Verfahren abgeschiedene Schicht ist.

7. Verfahren zur Herstellung von Beschichtungen auf Schweiß- und/oder Lötvorrichtungen, **dadurch gekennzeichnet, daß** mittels eines Gasabscheideverfahrens, vorzugsweise durch ein CVD- oder PVD-Verfahren, zumindest auf den den metallischen Verunreinigungen ausgesetzten Oberflächenbereichen dieser Vorrichtungen eine diamantartige Kohlenstoffschicht abgeschieden wird.

8. Verfahren nach Anspruch 7, **dadurch gekennzeichnet, daß** als diamantartige Schicht eine Schicht aus a-C:H, Me-C:H oder Si-C:H abgeschieden wird.

9. Verfahren nach mindestens einem der Ansprüche 7 bis 8, **dadurch gekennzeichnet, daß** als diamantartige Schicht eine Schicht aus Me-C:H abgeschieden wird, bei der der Me-Gehalt zwischen 10% und 49,9% liegt.

10. Verfahren nach mindestens einem der Ansprüche 7 bis 9, **dadurch gekennzeichnet, daß** als diamantartige Schicht eine Schicht aus Me-C:H abgeschieden wird, bei der das Metall W, Zr, Cr, Au, Ag, Pt, Cu, Ta, Hf, V, oder Ti enthält.

11. Verwendung einer kohlenstoffhaltigen Beschichtung nach einem der Ansprüche 1 bis 6 zur Verhinderung des Anhaftens metallischer Verunreinigungen auf der Oberfläche von Schweiß- oder Lötvorrichtungen.

12. Verwendung einer kohlenstoffhaltigen Beschichtung nach Anspruch 11 zum Schutz von Schweißbacken und Schweißdüsen.

13. Verwendung einer kohlenstoffhaltigen Beschichtung nach Anspruch 11 zum Schutz von Fixier-, Führungs- und Halteeinrichtungen von Schweiß- und Lötaniagen.

14. Verwendung einer kohlenstoffhaltigen Beschichtung nach einem der Ansprüche 1 bis 6 zur Verhinderung des Anhaftens metallischer Verunreinigungen auf der Oberfläche von elektrischen Kontakten, insbesondere von Kontaktstiften, Kontaktfedern und Kontaktklemmen.

## Claims

1. An anti-adhesion coating for welding and/or soldering devices and electrical contacts, for reducing the adhesion of metallic impurities to their surfaces, **characterized in that** the coating is a diamond-like carbon coating.

2. A coating according to claim 1, **characterized in that** the coating is a layer of a-C, a-C:H, Me-C:H or Si-C:H.

3. A coating according to at least one of claims 1 and 2, **characterized in that** the coating is a layer of Me-C:H, wherein the metal is W, Zr, Cr, Au, Ag, Pt, Cu, Ta, Hf, V or Ti.

4. A coating according to at least one of claims 2 and 3, **characterized in that** the metal content lies between 10% and 49.9%.

5. A coating according to at least one of claims 1 to 4, **characterized in that** the coating has a thickness between 0.2 µm and 15 µm.

6. A coating according to at least one of claims 1 to 5, **characterized in that** the coating is layer deposited by gas phase deposition, especially by a CVD or PVD method.

7. A method of producing coatings on welding and/or soldering devices, **characterized in that** a diamond-like carbon layer is deposited by a gas deposition method, preferably by a CVD or PVD method, on the surfaces of these devices subject to the metallic impurities.

8. A method according to claim 7, **characterized in that** a layer of a-C:H, Me-C:H or Si-C:H is deposited as a diamond-like layer.

9. A method according to at least one of claims 7 and 8, **characterized in that** a layer of Me-C:H is deposited as a diamond-like layer, in which the metal content lies between 10% and 49.9%.

10. A method according to at least one of claims 7 to 9, **characterized in that** a layer of Me-C:H is deposited as a diamond-like layer, wherein the metal comprises W, Zr, Cr, Au, Ag, Pt, Cu, Ta, Hf, V or Ti.

11. Use of coating containing carbon according to any of claims 1 to 6 for preventing the adhesion of metallic impurities on the surface of welding or soldering devices.

12. Use of a coating containing carbon according to claim 11 for protecting welding jaws and welding nozzles.

13. Use of a coating containing carbon according to claim 11 for protecting locating, guide and holding devices of welding and soldering apparatus.

14. Use of a coating containing carbon according to at least one of claims 1 to 6 for preventing the adhesion of metallic contaminants on the surface of electric contacts, especially contact pins, contact springs and contact clips.

## Revendications

1. Revêtement anti-adhésif pour dispositifs de soudure et/ou de brasure, et pour contacts électriques en vue de réduire l'adhésion d'impuretés métalliques sur leurs surfaces,
**caractérisé en ce que**
le revêtement est une couche de carbone du type diamant.

2. Revêtement selon la revendication 1,
**caractérisé en ce que**
le revêtement est une couche en a-C, a-C : H, Me-C : H, ou Si-C : H.

3. Revêtement selon au moins l'une des revendications 1 à 2,
**caractérisé en ce que**
le revêtement est une couche en Me-C : H, dans laquelle le métal est W, Zr, Cr, Au, Ag, Pt, Cu, Ta, Hf, V ou Ti.

4. Revêtement selon au moins l'une des revendications 2 à 3,
**caractérisé en ce que**
la teneur en métal se situe entre 10 et 49,9 %.

5. Revêtement selon au moins l'une quelconque des revendications 1 à 4,
**caractérisé en ce que**
le revêtement possède une épaisseur comprise entre 0,2 µm et 15 µm.

6. Revêtement selon au moins l'une quelconque des revendications 1 à 5,
**caractérisé en ce que**
le revêtement est une couche déposée par séparation de phase gazeuse, en particulier une couche déposée par un procédé CVD ou PVD.

7. Procédé de préparation de revêtements sur des dispositifs de soudage et/ou de brasage,
**caractérisé en ce qu'**
à l'aide d'un procédé de séparation gazeuse, de préférence par un procédé CVD ou PVD, au moins sur les zones superficielles exposées aux impuretés métalliques de ces dispositifs, on dépose une couche de carbone du type diamant.

8. Procédé selon la revendication 7,
**caractérisé en ce que**
comme couche du type diamant, on dépose une couche en a-C :H, Me-C :H, ou SiC :H.

9. Procédé selon au moins l'une quelconque des revendications 7 à 8,
**caractérisé en ce que**
comme couche du type diamant on dépose une couche en Me-C :H pour laquelle la teneur en ME se situe entre 10 et 49,9 %.

10. Procédé selon au moins l'une quelconque des revendications 7 à 9,
**caractérisé en ce que**
comme couche du type diamant, on dépose une couche en Me-C : H dans laquelle le métal renferme du W, Zr, Cr, Au, Ag, Pt, Cu, Ta, Hf, V ou Ti.

11. Utilisation d'un revêtement contenant du carbone, selon l'une quelconque les revendications 1 à 6, pour empêcher l'adhésion d'impuretés métalliques sur les surfaces de dispositifs de soudage ou de brasage.

12. Utilisation d'un revêtement contenant du carbone, selon la revendication 11, en vue de la protection des mâchoires et des buses de soudage.

13. Utilisation d'un revêtement contenant du carbone, selon la revendication 11 en vue de la protection d'assemblages de fixation, de guidage et de blocage d'installations de soudage et de brasage.

14. Utilisation d'un revêtement contenant du carbone selon l'une quelconque des revendications 1 à 6, en vue d'empêcher l'adhésion d'impuretés métalliques à la surface de contacts électriques, en particulier de pointes de contact, de ressorts de contact et de pinces de contact.
